# FASCICULE DE BREVET EUROPEEN

(11) **EP 0 541 456 B1**
(45) Date de publication et mention de la délivrance du brevet: **04.01.1995**
(21) Numéro de dépôt: 92420375.5
(22) Date de dépôt: 22.10.1992
(51) Int. Cl.: H05K 7/20

(54) **Support de carte de composants électroniques à faible résistance thermique**
Elektronischer Baugruppenträger mit niedrigem thermischem Widerstand
Support for card with electronic components having a low thermal resistance

(30) Priorité: 24.10.1991 FR 9113361
(43) Date de publication de la demande: 12.05.1993
(73) Titulaire: TRANSCAL, 92400 Courbevoie (FR)
(72) Inventeur: Lebailly, Michel, F-84500 Bollene (FR); Taverdet, Jean-Claude, F-84100 Orange (FR)
(74) Mandataire: Mougeot, Jean-Claude

(56) Documents cités:
- EP-A- 0 393 496
- US-A- 4 847 731
- ELECTRONIQUE INDUSTRIELLE no. 114, Octobre 1986, PARIS FR, pages 37 - 39 GERARD PEROT 'LES COMPOSITES COLAMINES DANS LA FABRICATION DES CIRCUITS IMPRIMES'
- IEEE 1985 NATIONAL AEROSPACE AND ELECTRONICS CONFERENCE vol. 2, 20 Mai 1985,DAYTON,US pages 1244 - 1247; A. BASIULIS AND C. P. MINNING 'IMPROVED RELIABILITY OF ELECTRONIC CIRCUITS THROUGH THE USE OF HEAT PIPES'
- NTIS TECH NOTES Juin 1991, SPRINGFIELD, VA US,page 463;S. WALTER PETRICK'Oscillating thermal switch'

## Description

### DOMAINE TECHNIQUE

L'invention concerne un support de carte portant des composants électroniques, ledit support ayant une faible résistance thermique permettant d'évacuer aisément une quantité de chaleur accrue, dégagée par lesdits composants, en direction d'un châssis faisant office de puits thermique.

### ETAT DE LA TECHNIQUE

Les composants électroniques sont habituellement fixés sur des cartes comportant des circuits imprimés d'interconnexion entre lesdits composants. Ces cartes sont en général munies de dispositif de liaisons électriques qui permettent de les enficher dans des châssis (ou racks) métalliques ouverts ou fermés (formant coffret) par l'intermédiaire de glissières, également métalliques, dans lesquelles elles coulissent. Elles sont évidemment isolants électriques mais suffisamment bons conducteurs thermiques.

Quand les composants dégagent de la chaleur, cette dernière doit être évacuée pour qu'ils ne soient pas détériorés. La température à ne pas dépasser est d'environ 125°C pour éviter toute augmentation du risque du taux de panne (plus connu généralement par l'expression "mean time between failure" ou "MTBF").

Quand les cartes sont en résine époxy ou en complexe fibre de verre-résine époxy ou autre matière similaire peu conducteur de la chaleur, cette dernière peut être évacuée à l'aide de drains thermiques qui relient les composants aux glissières de maintien de la carte, lesdites glissières étant solidaires du châssis qui fait office de radiateur ou puits thermique.

Un tel dispositif est insuffisant quand les quantités de chaleur à évacuer augmentent. Aussi on a proposé d'utiliser des cartes de constitution plus élaborée. Ces cartes comprennent en général deux plaques planes extérieures parallèles, constituant deux cartes imprimées proprement dites ou deux circuits céramiques d'inter-connexion (que l'on désignera par la suite également par l'appelation carte imprimée), sur lesquelles sont fixés les composants électroniques; elles enserrent un support métallique, également plan, bon conducteur thermique.

Les cartes imprimées sont isolant électrique mais doivent cependant avoir une conductibilité thermique acceptable. Ainsi on choisit généralement comme matériau des cartes imprimées des plaques minces d'alumine frittée et, comme matériau du support, des sandwiches métalliques colaminés du type Cu-invar®-Cu, ou Cu - Mo - Cu qui ont le même coefficient de dilatation que l'alumine.

La capacité d'évacuation de chaleur de ce dispositif peut être augmentée en faisant circuler un fluide de refroidissement dans le support métallique. Mais cela nécessite, en plus des dispositifs de connexion électrique de la carte imprimée, la présence de dispositifs de connexion hydraulique des circuits de refroidissement entre le support métallique de la carte et le châssis; ainsi les connexions hydrauliques se trouvent imbriquées au milieu des connexions électriques.

On connaît aussi, d'après le document IEEE 1985, National Aerospace and Electronics Conference (vol.2, 20 mai 85 Dayton US, p. 1244-47), un support de carte constitué de plusieurs enceintes caloduc élémentaires remplies d'une structure capillaire sous forme de mèche et d'une petite quantité de liquide vaporisable contenues dans une carcasse alvéolaire fermée par des plaques. Une telle structure n'est pas suffisamment homogène et peut présenter des risques de points chauds dus à la présence des éléments constitutifs de la carcasse.

On voit que la quantité de chaleur évacuable est limitée par la résistance thermique de la chaîne allant des composants électroniques au châssis, ce dernier ayant évidemment la capacité suffisante de dissipation de la chaleur qui lui est amenée.

Ainsi la demanderesse a cherché à diminuer la résistance thermique du support de carte imprimée qui est une pièce essentielle de ladite chaîne; elle assure en effet la liaison thermique entre la carte imprimée, supportant les composants électroniques générateurs de chaleur, et les glissières du châssis qui assurent le contact thermique avec ledit châssis dissipant la chaleur.

Elle a également cherché à avoir une très grande homogénéité de température du support de carte imprimée de façon à éviter tout échauffement local nuisible aux composants électroniques.

En conséquence l'invention a également pour but de pouvoir disposer d'un support de carte imprimée de caractéristique thermique améliorée lui permettant d'évacuer un plus grand flux thermique en augmentant par exemple la puissance ou la densité des composants fixés sur les cartes imprimées.

La demanderesse a également recherché un support de carte imprimée de réalisation et de mise en oeuvre aisées.

### DESCRIPTION DE L'INVENTION

L'invention est un support de carte imprimée (ou circuit céramique d'interconnexion), sur laquelle sont montés des composants électroniques, support permettant d'évacuer une quantité accrue de chaleur dégagée par lesdits composants en direction d'un châssis dissipateur d'énergie avec lequel il est en contact thermique et comportant une enceinte caloduc, caractérisé en ce qu'il comprend deux plaques planes métalliques parallèles de forme identique délimitant entre elles un volume unique de grandes dimensions horizontales et de faible épaisseur que l'on clôt entièrement le long du pourtour desdites plaques, lequel volume est entièrement rempli d'un matériau métallique poreux de garnissage en contact avec lesdites plaques et est rempli partiellement par un liquide de travail vaporisable à la température de fonctionnement du support en équilibre uniquement avec sa vapeur.

Les cartes imprimées sont en général en céramique isolant électrique et ayant la meilleure conductibilité thermique possible. On emploie habituellement l'alumine frittée, mais d'autres céramiques sont utilisables, par exemple nitrure d'aluminium, oxyde de béryllium, carbure de silicium... Leur épaisseur est déterminée de façon à avoir simultanément une faible résistance thermique et une tenue mécanique suffisante.

La nature des plaques métalliques, sur lesquelles sont fixées les cartes imprimées, est choisie de façon à avoir un coefficient de dilatation adapté à celui de la carte imprimée. Par exemple quand la carte est en alumine, on choisit avantageusement des plaques colaminées cuivre-invar®-cuivre, ou Cu-Mo-Cu.

Le support selon l'invention se présente donc sous la forme d'une plaque creuse parallélépipédique, entièrement et hermétiquement fermée sur son pourtour, de faible épaisseur (généralement quelques mm) ; l'espace intérieur, intéressant la totalité de la surface des plaques, est complètement occupé par le matériau métallique poreux et partiellement rempli par le liquide de travail en équilibre uniquement avec sa vapeur.

Le fonctionnement du support selon l'invention peut se résumer de la façon suivante. La chaleur émise par certains composants électroniques est transmise au liquide, présent à cet endroit du support, qui se vaporise; la vapeur va alors se condenser en une zone froide, tandis que du liquide retourne dans la zone chaude grâce à la capillarité du milieu poreux et quelle que soit l'orientation du support.

La chaleur à évacuer gagne ainsi les zones les plus froides du support qui sont les glissières, où est inséré le support, et donc le châssis dissipateur de chaleur.

Le support de carte imprimée selon l'invention peut être considéré comme une enceinte caloduc unique de grandes dimensions horizontales et de faible épaisseur fonctionnant dans toutes les orientations.

En cela, il se distingue du support de carte imprimée du document IEEE 1985, cité ci-dessus, qui comporte une pluralité d'alvéoles faisant office de caloducs élémentaires. Ainsi on peut voir qu'il est de conception et de réalisation plus simples; en particulier, étant constitué d'une enceinte unique caloduc non compartimentée par des montants d'une certaine épaisseur, il comporte moins de volume mort et donc présente une capacité et une homogénéité d'échange thermique améliorées; de plus il ne nécessitera qu'une seule opération délicate de remplissage.

Grâce à l'utilisation de la chaleur latente de vaporisation d'un plus grand volume de liquide de travail, il pourra transporter des quantités accrues de chaleur, des points chauds aux points froids et "in fine" au dissipateur de chaleur, et également sa température de fonctionnement se trouvera mieux uniformisée grâce à l'absence de montants délimitant des alvéoles, toute la surface du support étant une surface évaporatrice homogène.

De plus, il ne nécessitera qu'une seule opération de remplissage en liquide de travail, lesquelles opérations sont en général délicates.

Les modalités de mise en oeuvre de l'invention sont variées.

Pour améliorer la rigidité du support et le transfert de chaleur entre les plaques planes extérieures et le remplissage intérieur (matériau poreux et liquide), il est avantageux de mettre des entretoises entre les deux plaques tout en conservant le volume unique. Selon un mode particulier de réalisation ces entretoises peuvent être constituées d'une feuille métallique, pleine ou perforée, ondulée par exemple en forme de sinusoïde, le sommet des sinusoïdes étant fixé (par exemple brasé) sur la face intérieure des plaques, l'aspect général obtenu ressemblant à du carton ondulé et une telle feuille métallique n'occupant qu'une partie du volume unique; une structure de ce type est produite par la Société Metal Imphy à partir de ses colaminés Cu-invar®-Cu, de marque Phyclad, dont le coefficient de dilatation est avantageusement adapté aux cartes imprimées à base d'alumine. Le matériau métallique poreux et le liquide prennent alors place entre les sinusoïdes et les plaques planes.

Le matériau métallique poreux peut être constitué de métal fritté, de tissu ou de mêches métalliques tricotés ou tressés, de bourre de fibres ou de mousse métalliques etc... Le métal peut être Cu, Ni, Al, en général tous les métaux bons conducteurs de la chaleur. La forme, le nombre, la dimension des fils métalliques peut être variable, par exemple: fils ronds ou avec méplat, diamètre de 0,05 mm à 0,5 mm. L'important est que compte tenu du liquide et du métal utilisés, on ait une pression capillaire suffisante pour que ledit liquide puisse circuler, malgré la pesanteur ou des accélérations négatives ou quelle que soit l'orientation du support, sans que l'on augmente excessivement la perte de charge qui s'oppose au déplacement de la vapeur.

Ainsi quand le support comporte une entretoise sinusoïdale, on peut introduire des mèches métalliques tressées ou tricotées dans les canaux de la sinusoïde, et compléter ensuite par une mèche transversale recouvrant toutes les extrémités des mèches émergeant desdits canaux.

Le liquide de travail, servant au transfert de calories, a en général un point d'ébullition inférieur à 125°C, de bonnes stabilité et inertie chimiques, la plus forte chaleur latente de vaporisation possible, et est de préférence isolant électrique. On peut ainsi utiliser l'eau, les fluorocarbones ou chlorofluorocarbones, certains alcools ou des mélanges de liquide, par exemple eau-méthanol, etc... Il est en général introduit dans le support après y avoir fait un vide et un dégazage complet de façon à éliminer toute trace de gaz incondensable qui nuirait au bon fonctionnement du support; il est donc uniquement en équilibre avec sa vapeur.

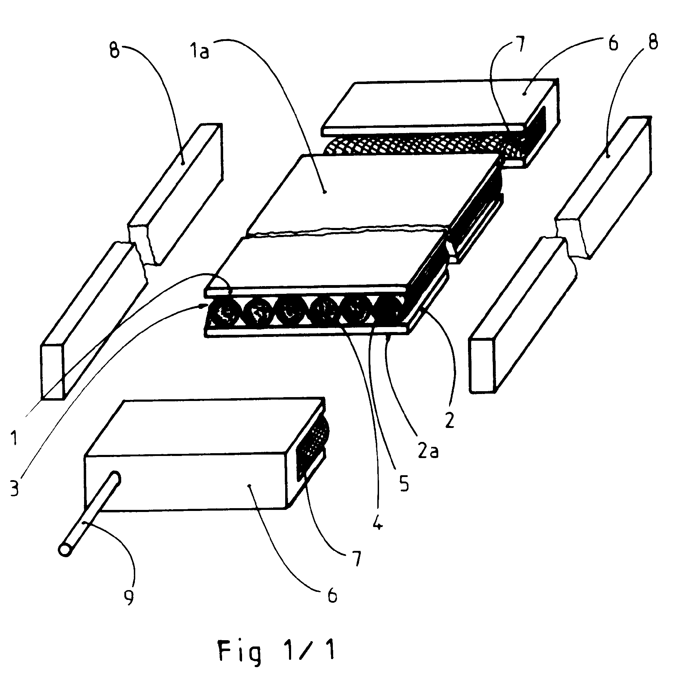

Un exemple non limitatif de réalisation est donné par la fig.1 qui est une vue éclatée d'un support de carte rectangulaire plan avant fermeture et dont la longueur a été tronquée. Les repères (1) et (2) représentent respectivement des plaques planes métalliques supérieure et inférieure en colaminé Cu-invar®-Cu; sur chacune de leur surface plane extérieure (la) et (2a) est fixée une carte imprimée supportant les composants électroniques (non représentés). Dans l'espace (3) situé entre les plaques (1) et (2) on note l'entretoise (4) qui est une tôle pleine ondulée en forme de sinusoïde dont les sommets sont fixés sur les faces intérieures des plaques (1) et (2). Dans cette réalisation la section transversale sinusoïdale de la tôle entretoise est perpendiculaire au grand axe du rectangle formé par les plaques (1) et (2).

Dans les canaux formés par l'onde sinusoïdale et les plaques (1) et (2) ont été introduites des mèches métalliques (5) tressées, en cuivre, qui émergent à chaque extrémité des canaux.

Dans le cas présent, l'espace (3) est fermé sur chacun de ses petits côtés à l'aide d'un bouchon creux (6) de même largeur et épaisseur que l'ensemble sandwich formé par les plaques (1) et (2) et l'entretoise (4); ledit bouchon creux (6) ayant une section en forme de U, on y introduit également de la tresse ou de la bourre métallique (7) qui, une fois qu'on aura abouté le bouchon (6) sur les plaques (1) et (2), viendra recouvrir les extrémités des mèches (5) dépassant des canaux de façon à avoir une continuité thermique. Les grands côtés de l'espace (3) sont fermés, à leur tour, par des barrettes parallélépipédiques (8) obturant également les bords de l'espace en U des bouchons (6). Un des bouchons (6) porte un queusot (9) destiné à effectuer l'opération de remplissage en liquide de travail de l'espace (3); ce queusot (9) est ensuite obturé définitivement.

Le support de carte imprimé selon l'invention n'est pas limité en dimension et peut par exemple s'appliquer à la réalisation de supports de dimensions 140 à 170 mm x 80 à 100 mm (correspondant au standard de format 1/2 ATR). Il possède une conductibilité thermique globale remarquable, nettement supérieure (de plusieurs puissances de 10) à celle obtenue avec un support uniquement à base de cuivre, ou métallique refroidi par circulation de fluide, sans présenter les inconvénients de ces derniers dus aux branchements hydrauliques délicats à effectuer. Ainsi il permet d'évacuer sans problème des puissances atteignant 5 à 6 W/cm² en tous points de la surface du support.

Grâce à son mode de fonctionnement il opère également une répartition homogène de la température dans le support et supprime la présence de points chauds préjudiciables à l'obtention d'un faible taux de risque de panne de la carte imprimée et des composants.

On peut également adapter son coefficient de dilatation à celui de la carte imprimée, par le choix des matériaux de constitution.

Par le choix judicieux des matériaux de remplissage du volume clos (matériau poreux métallique et liquide de travail) on peut faire varier, et adapter aux besoins, la conductibilité thermique globale du support.

Grâce en particulier à la capillarité adaptée du matériau poreux, la conception du remplissage de l'espace clos permet au support de fonctionner, non seulement dans toutes les orientations comme cela a été déjà dit, mais également sous des accélérations négatives: ceci le rend particulièrement apte à être utilisé pour l'équipement électronique de puissance d'engins de transport, entre autres des aéronoefs, ou de plus, sa simplicité de fonctionnement, de mise en place et d'utilisation, sa légèreté par rapport à des supports métalliques pleins, sa compacité identique à celle d'un support habituel, sont des atouts importants.

## Revendications

1. Support de carte imprimée, sur laquelle sont montés des composants électroniques, support permettant d'évacuer une quantité accrue de chaleur dégagée par lesdits composants en direction d'un châssis dissipateur d'énergie avec lequel il est en contact et comportant une enceinte caloduc, caractérisé en ce qu'il comprend deux plaques planes métalliques parallèles de forme identique (1, 2), délimitant entre elles un volume unique (3) de grandes dimensions horizontales et de faible épaiseur que l'on clôt entièrement le long du pourtour desdites plaques, lequel volume unique est entièrement rempli d'un matériau métallique poreux de garnissage (5) en contact avec lesdites plaques et est rempli partiellement par un liquide vaporisable à la température de travail dudit support en équilibre uniquement avec sa vapeur.

2. Support selon la revendication 1 caractérisé en ce que ledit support est enfiché dans des glissières solidaires du châssis faisant office de puits thermique.

3. Support selon l'une quelconque des revendications caractérisé en ce que les plaques planes sont séparées par des entretoises (4).

4. Support selon la revendication 3 caractérisé en ce que les entretoises sont constituées par une feuille métallique pleine ondulée en forme de sinusoïde n'occupant qu'une partie du volume unique.

5. Support selon l'une quelconque des revendications 1 à 4 caractérisé en ce que les plaques sont en colaminé Cu-invar®-Cu pour des cartes imprimées en alumine frittée.

6. Support selon l'une quelconque des revendications 1 à 5 caractérisé en ce que le matériau poreux est constitué de métal fritté, de tissu, de bourre de fibre, de mousse ou de mèches métalliques.

## Patentansprüche

1. Träger für Leiterplatten, auf denen elektronische Bauelemente montiert sind, welcher Träger die Abführung einer großen, von diesen Bauelementen freigesetzten Wärmemenge in Richtung eines Energie dissipierenden Chassis ermöglicht, mit dem er in Kontakt ist, und der eine Wärmekanalhülle (enceinte caloduc) umfaßt,
dadurch gekennzeichnet, daß
er zwei parallele ebene metallische Platten von identischer Form (1, 2) umfaßt, die zwischeneinander ein einheitliches Volumen (3) mit großen horizontalen Ausmaßen und geringer Dicke begrenzen, das entlang des Randes der Platten vollständig verschlossen ist, wobei das einheitliche Volumen vollständig mit porösem metallischen Füllmaterial (5) gefüllt ist, das mit den Platten in Kontakt ist, und teilweise mit einer bei der Betriebstemperatur des Trägers verdampfbaren Flüssigkeit gefüllt ist, die allein mit ihrem Dampf im Gleichgewicht steht.

2. Träger nach Anspruch 1, dadurch gekennzeichnet, daß der Träger in Gleitschienen des Chassis eingeschoben ist, das als Wärmesenke dient.

3. Träger nach einem der Ansprüche 1 bis 2, dadurch charakterisiert, daß die ebenen Seiten durch Verstrebungen (4) getrennt sind.

4. Träger nach Anspruch 3, dadurch gekennzeichnet, daß die Verstrebungen aus einem sinusförmig gewellten massiven Blech bestehen, das nur einen Teil des einheitlichen Volumens belegt.

5. Träger nach einem der Ansprüche 1 bis 4, dadurch gekennzeichnet, daß die Platten aus Cu-Invar®-Cu-Kolaminat für gedruckte Leiterplatten aus gesintertem Aluminiumoxid bestehen.

6. Träger nach einem der Ansprüche 2 bis 5, dadurch gekennzeichnet, daß das poröse Material aus gesintertem Metall, Metallgewebe, -faserflocken, -schaum oder -dochten besteht.

## Claims

1. A printed card carrier on which electronic components are mounted, the said carrier making it possible to dissipate an increased quantity of heat given off by the said components in the direction of an energy dissipating chassis with which it is in contact and comprising a heat conductive enclosure, characterised in that it comprises two parallel flat metal plates (1, 2) of identical shape defining between them a single space (3) of large horizontal dimensions and limited width, which is closed entirely along the periphery of the said plates, the said single space being entirely filled by a porous metallic lining material (5) which is in contact with the said plates and which is partially filled by a liquid which can evaporate at the working temperature of the said carrier in equilibrium solely with its vapour.

2. A carrier according to claim 1, characterised in that the said carrier is plugged into rails rigid with the frame acting as a heat sink.

3. A carrier according to any one of the claims, characterised in that the flat plates are separated by spacers (4).

4. A carrier according to claim 3, characterised in that spacers are constituted by an undulating solid metal sheet of sinusoidal form which occupies only apart of the single space.

5. A carrier according to any one of claims 1 to 4, characterised in that the plates are of a Cu-invar^{(R)}-Cu laminate in the case of printed cards of sintered alumina.

6. A carrier according to any one of claims 1 to 5, characterised in that the porous material consists of a sintered metal, a woven material, fibre flock, foam or metal cords.
